# EUROPÄISCHE PATENTSCHRIFT

(11) **EP 1 867 376 B1**
(45) Veröffentlichungstag und Bekanntmachung des Hinweises auf die Patenterteilung: **21.10.2009**
(21) Anmeldenummer: 07002402.1
(22) Anmeldetag: 05.02.2007
(51) Int. Cl.: B01D 46/10, H05K 7/20

(54) **Filterlüfter mit einer Schnellbefestigungseinrichtung**
Filter fan with a rapid fastening device
Ventilateur a filtre comprenant un dispositif de fixation rapide

(30) Priorität: 13.06.2006 DE 202006009355 U
(43) Veröffentlichungstag der Anmeldung: 19.12.2007
(60) Teilanmeldung: 09010435.7
(73) Patentinhaber: Pfannenberg GmbH, 21035 Hamburg (DE)
(72) Erfinder: Pfannenberg, Andreas, 21035 Hamburg (DE)
(74) Vertreter: Richter, Werdermann, Gerbaulet & Hofmann

(56) Entgegenhaltungen:
- EP-A- 0 352 113
- EP-A- 1 720 395
- EP-A1- 1 370 125
- US-A1- 2002 094 772
- US-B1- 6 189 848

## Beschreibung

Die Erfindung betrifft einen Filterlüfter mit einer Schnellbefestigungseinrichtung.

Zur Belüftung von Schaltschränken, elektronischen Steuereinrichtungen und Computern dienen Filterlüfter, die in eine korrespondierende Öffnung in einer Gehäusewand beispielsweise eines Schaltschranks eingesetzt sind. Die Filterlüfter verfügen über ein Gebläse, um Umgebungsluft in das Gehäuse hineinzufördern, wobei das Gehäuse zusätzlich mit Luftaustrittsschlitzen versehen ist. Um eine Verunreinigung der elektronischen Einrichtungen im Gehäuse zu vermeiden, verfügt der Filterlüfter über eine Filtereinrichtung, beispielsweise in Form einer austauschbaren Filtermatte.

Ein derartiger Filterlüfter ist aus der EP 0 439 667 B1 bekannt, wobei der Filterlüfter über ein Grundgehäuse mit einem Rahmen verfügt. An dem Rahmen sind Schnellbefestigungseinrichtungen in Form von federelastischen Laschen ausgebildet, um den Filterlüfter ohne zusätzliche Schrauben oder sonstige Montagemittel werkzeuglos in eine Gehäuseöffnung einsetzen und dort mit Hilfe der federelastischen Laschen verrasten zu können.

Des weiteren ist nach der DE 20 2006 009 355.9 ein Filterlüfter mit einem Grundgehäuse mit einem Rahmen bekannt, wobei der Rahmen mit Schnellbefestigungseinrichtungen in Form von federelastischen bevorzugterweise flügelartigen Laschen versehen ist. Der Rahmen ist um seinen Umfang durchgehend umlaufend geschlossen ausgebildet, wobei die Laschen an den Rahmen angeformt sind. Bei diesem Filterlüfter sind die Schnellbefestigungseinrichtungen in Form federelastischen Laschen nicht aus einem Abschnitt einer Seitenwand bzw. eines Rahmens des Grundgehäuses des Filterlüfters ausgeschnitten, sondern außenseitig an diesem Rahmen bzw. den Seitenwänden angeformt. Der Filterlüfter bzw. dessen Grundgehäuse besteht aus einem Kunststoff-Spritzgussteil, so dass bei der Herstellung des Rahmens bereits die zusätzlichen Laschen einstückig mit dem Rahmen an diesem angeformt oder ausgebildet werden können. Die Laschen sind dabei quasi außenseitig am Rahmen angeordnet und weisen beispielsweise in einem Ausschnitt in einer Montagewand im montierten Zustand des Filterlüfters nach außen. Außerdem ist der Rahmen um den Umfang des Filterlüfters gesehen umlaufend durchgehend ausgebildet, beispielsweise als ein einziges Bauteil. Durch das zusätzliche Anformen von federelastischen Laschen am Rahmen des Filterlüfters sind keine Öffnungen mehr in seitlichen Außenwänden vorhanden und der Rahmen ist im Wesentlichen durchgehend um den Umfang des Filterlüfters geschlossen ausgebildet. Somit ist das Eindringen von ungefilterter Luft, beispielsweise in ein Computergehäuse, wirkungsvoll vermieden. Ebenso kann kein Wasser durch die Seitenwände in das Innere des Filters eindringen und sich somit eine Filtermatte nicht mehr mit Feuchtigkeit voll saugen.

Als nachteilig hierbei ist es jedoch anzusehen, dass in lackierten Blechausschnitten einer Montagewand eine unzureichende Rastung der Laschen im Kantenbereich der Blechausschnitte erhalten wird, was darauf zurückzuführen ist, dass der umlaufende Rand des Blechausschnittes die für eine einwandfreie Rastung erforderliche Ausbildung scharfer Kanten nicht aufweist. Durch den Lackauftrag auf das Blech des Schaltschrankes u. a. auch im Rand- bzw. Kantenbereich der Blechausschnitte entfällt die für eine einwandfreie Rastung der Laschen erforderliche Scharfkantigkeit, so dass die durch den Lackauftrag entstehenden Abrundungen im Kantenbereich keinen ausreichenden Halt der Laschen in den Rand- bzw. Kantenbereichen der Blechausschnitte gewährleisten. Hinzukommt, dass bei diesem Filterlüfter die gesamte Ecke der Schnellbefestigung auf einer schrägen Kontur klemmt, so dass es sich dabei nicht um ein direktes Verrasten handelt, was dazu führt, dass der Sitz der Rastecken in lackierten Blechen aufgrund der gerundeten Kanten im Blechausschnitt durch die aufgebrachte Farbe und somit durch fehlende scharfe Kanten unzureichend sicher war und es somit zu einem selbstständigen Lösen des Filterlüfters aus seiner Halterung im Blechausschnitt des Schaltschrankes kommen konnte.

Die EP 1 720 395 A1 schlägt nun vor, am Rahmen des Grundgehäuses des Filterlüfters jeweils Gruppen von Rastlaschen an gegenüberliegenden Seitenwänden des Rahmens vorzusehen. Jede Gruppe besteht aus einer Anzahl von gleichartig ausgebildeten Rastlaschen, wobei der Abstand zwischen dem freien Ende einer Rastlasche und dem Flansch des Filtergehäuses, der im montierten Zustand an der Montagewand anliegt, variiert. So weisen die innenliegenden Rastlaschen den größten Abstand zwischen freiem Ende und Flansch und die außen im Eckbereich, in dem zwei Seitenwände des Rahmens aneinanderstoßen, angeordneten Rastlaschen den geringsten Abstand auf. Hierdurch wird erreicht, dass auch bei verschiedenen Wandstärken der Montagewand jeweils eine der Rastlaschen den Filterlüfter fest an der Montagewand verrastet.

Die EP 0 352 113 A2 offenbart eine Vorrichtung für Gasmasken, bei der ein Gehäuse mit darin befindlichem Filter an eine Gasmaske anschließbar ist, wobei an der der Gasmaske abgewandten Seite des Behälters wiederum ein sich in einem weiteren Gehäuse befindliches Gebläse befestigbar ist. An dem dem Filtergehäuse zugewandten Randbereich des Gebläsegehäuses sind umlaufend angeordnet parallele Schlitze vorgesehen, so dass sich eine Anzahl von Rastlaschen ergibt, die aus der Gehäusewand des Gebläses herausgeschnitten sind. Mit Hilfe dieser Rastlaschen ist das Gebläsegehäuse am Filtergehäuse befestigbar.

Die US 6,189,848 B1 zeigt ein Befestigungsblech mit integralen Federclips zur Befestigung von elektronischen Komponenten, wie beispielsweise Stromrichtern an Baugruppenträgern, wobei das Befestigungsmittel zur Reduzierung elektromagnetischer Interferenzen ausgebildet sein soll. An ein ebenes Grundblech sind bei dem Befestigungsmittel mehrere federnde Klemmzungen ausgebildet, mit denen eine elektronische Komponente an einer Wand eines Baugruppenträgers festgeklemmt werden kann, indem die Wand zwischen ebenem Grundblech und Klemmzungen eingeführt wird. Das Befestigungsmittel selbst wird mittels geeigneter Befestigungsmittel wie Schrauben am elektronischen Bauteil befestigt.

Die EP 1 370 125 A1 offenbart einen Filterlüfter mit einem Grundgehäuse mit einem Rahmen, wobei aus dem Rahmen in den Eckbereichen federelastische Laschen herausgeschnitten sind. Diese herausgeschnittenen federelastische Laschen wirken als Schnellbefestigungseinrichtung zur Montage des Filterlüfters in einem Wandauschnitt einer Montagewand. Des Weiteren umfasst der Filterlüfter ein EMV-Schirmblech mit einer Anzahl von federnden, elektrisch leitfähigen Kontaktzungen.

Es versteht sich, dass der Filterlüfter in an sich bekannter Weise zusätzlich mit einer Filtermatte und/oder einem Gebläse und/oder Luftleiteinrichtungen u. dgl. ausgestattet sein kann. Selbstverständlich können Lamellen, die als Luftleiteinrichtung dienen, auch schwenkbeweglich ausgebildet sein. Prinzipiell ist es möglich, dass an dem Rahmen lediglich eine einzige oder mehrere, bevorzugt wie im Folgenden beschrieben, federelastische Laschen angeordnet sind.

Der Erfindung liegt die Aufgabe zugrunde, einen Filterlüfter derart auszubilden, dass das Ansaugen von ungefilterter Luft und das Eindringen von Feuchtigkeit und Wasser in den Innenraum des Gehäuses des Filterlüfters vermieden wird und dass darüber hinaus die Schnellbefestigungseinrichtungen des Filterlüfters einfach aufgebaut sind, wobei trotzdem stets eine lösbare jedoch sichere Rastverbindung gewährleistet sein soll.

Diese Aufgabe wird durch die im Anspruch 1 angegebenen Merkmale gelöst.

Weitere vorteilhafte Ausführungsformen und Weiterentwicklungen der Erfindung sind Gegenstand der Unteransprüche.

An der umlaufenden Wandfläche des Rahmens des Grundgehäuses sind mindestens zwei plattenförmige Zuschnitte mit federelastischen Rastzungen angeformt, die jeweils an zwei sich gegenüberliegenden Seitenwandflächen des Rahmens an den Seitenwandflächen angeformt sind.

Die plattenförmigen Zuschnitte mit den federelastischen Rastzungen sind mittig der Seitenwandflächen des Rahmens des Grundgehäuses an den Seitenwandflächen angeformt.

Bei einer weiteren bevorzugten erfindungsgemäßen Ausführungsform sind vier plattenförmige Zuschnitte mit den federelastischen Rastzungen in den Eckbereichen des Grundgehäuses an den Seitenwandflächen des Rahmens angeformt, wobei die Anordnung der plattenförmigen Zuschnitte an jeweils zwei sich gegenüberliegenden Seitenwandflächen des Rahmens des Grundgehäuses vorgesehen sind.

Erfindungswesentlich ist, dass die federelastischen Rastzungen durch schlitzförmige Einschneidungen in jedem plattenförmigen Zuschnitt ausgebildet sind.

Dabei sind die Längen der federelastischen Rastzungen eines jeden plattenförmigen Zuschnittes in Richtung zu den äußeren Kanten zweier aneinander stoßenden Seitenwandflächen des Rahmens des Grundgehäuses abnehmend ausgebildet.

Jeder plattenförmige Zuschnitt mit seinen federelastischen Rastzungen besteht bevorzugterweise aus einem Kunststoff. Auch das Grundgehäuse des Filterlüfters kann aus einem Kunststoff bestehen.

Nach einer weiteren Ausführungsform der Erfindung bestehen der Filterlüfter und die plattenförmigen Zuschnitte mit den federelastischen Rastzungen aus dem gleichen Kunststoff.

Der Vorteil, der mit dem erfindungsgemäß ausgebildeten Filterlüfter erreicht wird, besteht darin, dass die bei den bekannten Filterlüftern ausgebildeten Rastecken in ihrer Formgebung zwar unverändert geblieben sind, lediglich durch Schlitzausbildungen wurden kleine Rastzungen geschaffen, die definiert hörbar verrasten. Entsprechend der unterschiedlichen Blechstärken der Montagewände kommt die jeweils zugehörige Rastzunge zum Eingriff und wird bei dünneren Blechen mit den bereits durchgedrückten Rastzungen zusätzlich gesichert, was dadurch möglich ist, dass die Längen der Rastzungen zum äußeren Kantenbereich hin sich verkürzen. Auf diese Weise ist ein sicheres Verrasten des Filterlüfters im Ausschnitt einer Montagewand unabhängig von der Blechstärke der Montagewand oder der Dicke der auf die Montagewand aufgetragenen Lackschicht gewährleistet.

Ausführungsbeispiele der Erfindung sind nachstehend anhand der Zeichnungen näher erläutert. Es zeigen:
- Fig. 1: einen Filterlüfter in einem senkrechten Schnitt,
- Fig. 2: eine Ansicht von vorn auf den Filterlüfter,
- Fig. 3: eine Rückansicht des Filterlüfters mit flügelartigen Laschen zur Schnellbefestigung des Filterlüfters an einer Montagewand,
- Fig. 4: eine Ansicht von oben auf den Rahmen des Filterlüfters mit den flügelartigen Laschen,
- Fig. 5: eine vergrößerte Ansicht eines Abschnittes des Rahmens des Filterlüfters mit einer flügelartigen Lasche,
- Fig. 6: eine weitere Ansicht von oben auf den Rahmen des Filterlüfters mit den flügelartigen Laschen,
- Fig. 7: eine Ansicht von oben auf den Filterlüfter mit in den Eckbereichen des Rahmens seines Grundgehäuses angeordneten flügelartigen Laschen mit in diesen ausgebildeten Rastzungen,
- Fig. 7A: eine vergrößerte Ansicht eines Eckbereiches des Rahmens gemäß Fig. 7 mit der flügelartigen, Rastzungen aufweisenden Lasche,
- Fig. 8: eine Seitenansicht des Filterlüfters mit in den Eckbereichen des Rahmens seines Grundgehäuses angeordneten flügelartigen Laschen mit den Rastzungen,
- Fig. 8A: eine vergrößerte Ansicht eines Eckbereiches des Rahmens gemäß Fig. 8 mit der Lasche,
- Fig. 9: eine schaubildliche Ansicht eines Eckbereiches des Filterlüfters mit der flügelartigen, Rastzungen aufweisenden Lasche,
- Fig. 10: eine schaubildliche Ansicht des in die Öffnung einer Montagewand eingesetzten Filterlüfters und
- Fig. 11: den in den Ausschnitt einer Montagewand eingesetzten Filterlüfter mit den flügelartigen Laschen im Querschnitt.

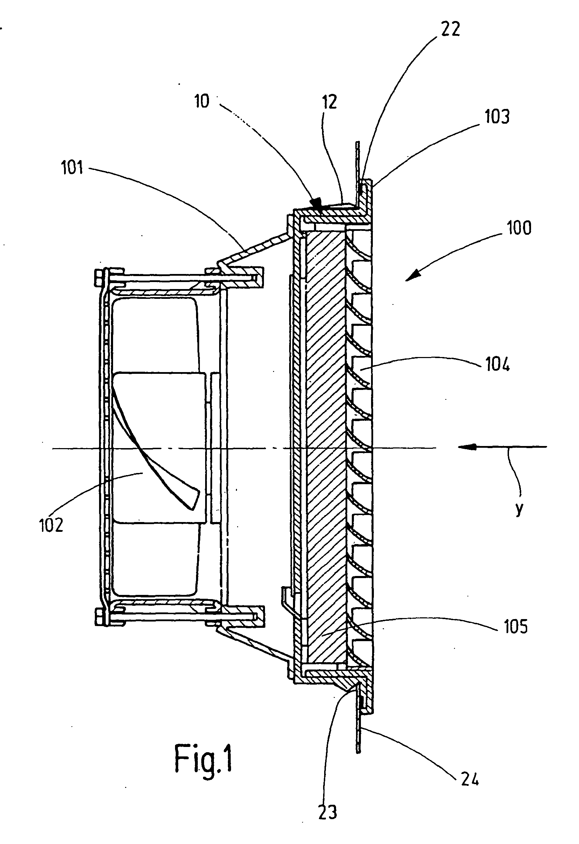

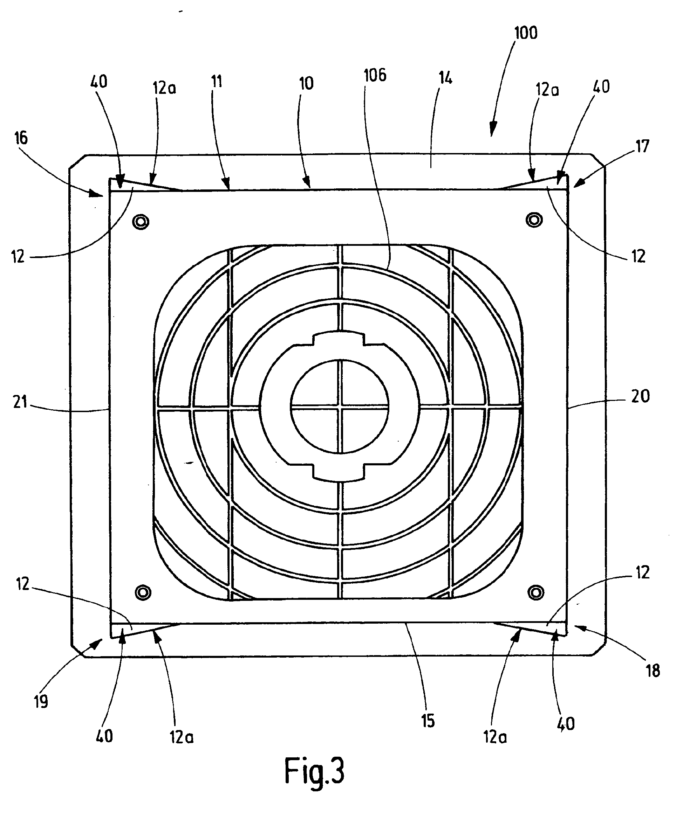

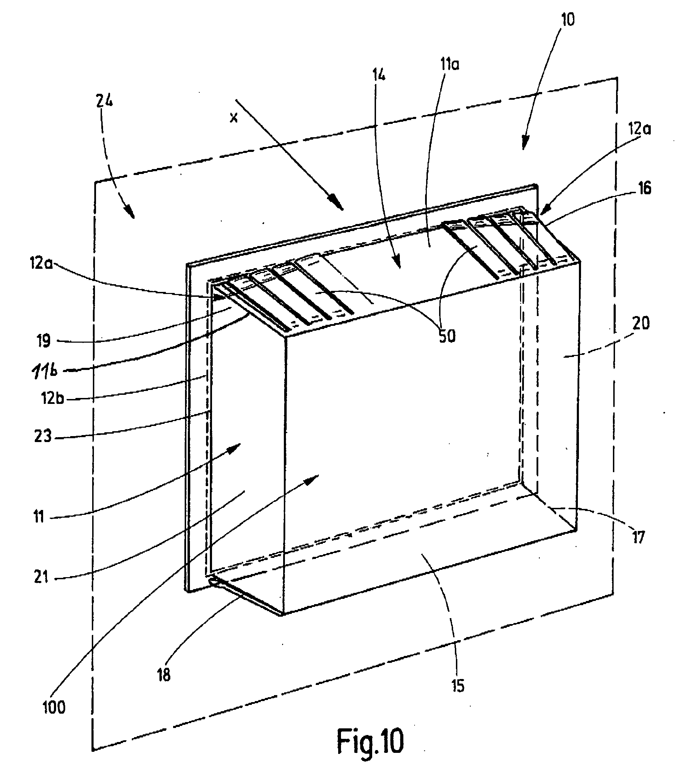

Der in den Fig. 1 bis 3 gezeigte Filterlüfter 100 besteht aus einem Grundgehäuse 10 mit einem Gebläseträger 101, der ein elektromotorisch betriebenes Gebläse 102 aufnimmt. Die offen ausgebildete Rückwand des Gebläseträgers 101 ist mittels eines Schutzgitters 106 verschlossen (Fig. 3). An das Grundgehäuse 10 ist vorzugsweise ein Rahmen 11 angeformt. Bei einem quadratischen oder rechteckigen Filterlüfter 100 besteht der Rahmen 11 aus vier Seitenwänden 14, 15, 20, 21 (Fig. 10).

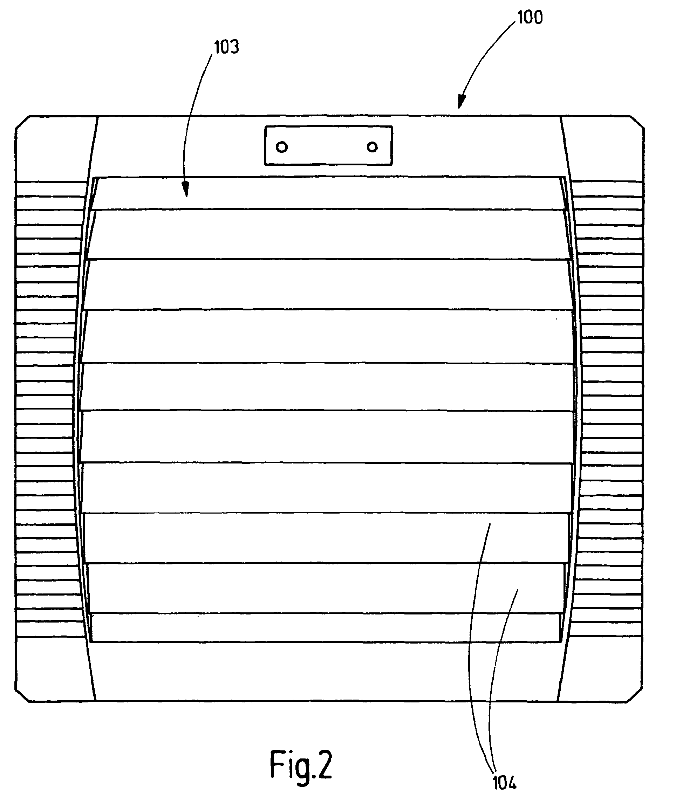

Das Grundgehäuse 10 weist vorderseitig einen Designdeckel 103 mit Luftleiteinrichtungen, beispielsweise in Form von Lamellen 104, auf (Fig. 1 und 2). Der Designdeckel 103 bzw. das Grundgehäuse 10 nimmt eine Filtermatte 105 zum Filtern der durch den Filterlüfter 100 in Pfeilrichtung Y geförderten Luft auf (Fig. 1). Der Filterlüfter 100 ist aus einem oder mehreren Kunststoff-Spritzgussteilen und/oder aus Metallteilen aufgebaut. Der Designträger 103 ist über eine umlaufende Dichtung 22 mit dem Grundgehäuse 10 bevorzugterweise lösbar verbunden, um die Filtermatte 105 austauschen zu können (Fig. 1).

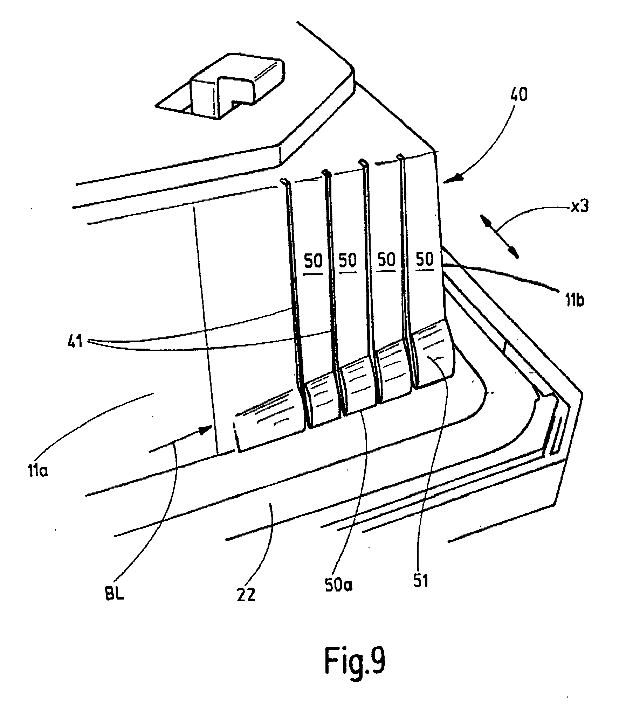

Der Filterlüfter 100 mit seinem Grundgehäuse 10 ist im eingebauten Zustand in einem Ausschnitt 23 in einer Montagewand 24, z. B. eines Schaltschrankes, angeordnet (Fig. 1). Die lösbare Befestigung bzw. Halterung des Filterlüfters 100 in dem Ausschnitt 23 der Montagewand 24 erfolgt über eine Rastverbindung mit an dem Rahmen 11 des Grundgehäuses 10 angeordneten Schnellbefestigungseinrichtungen 60, die als Rastelement 12a in Form von federelastischen Rastzungen 50 aufweisenden Laschen 12 ausgebildet sind (Fig. 9 und 10).

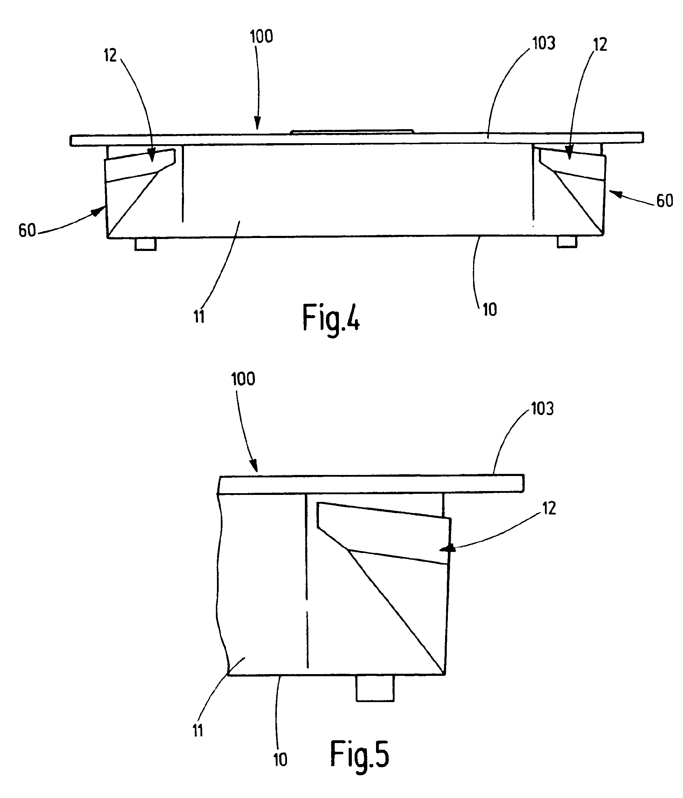

Zur lösbaren Befestigung des Filterlüfters 100 im Ausschnitt 23 der Montagewand 24 wird der Filterlüfter 100, wie durch den Pfeil X angegeben, in den Ausschnitt 23 eingeführt (Fig. 10). Dabei können die an dem Rahmen 11 angeformten, flügelartigen und federelastischen, Rastelemente (12a) bildende Laschen 12, wie durch den Doppelpfeil X3 verdeutlicht, geringfügig in Richtung zur Mitte des Ausschnitts 23 hin verbogen werden (Fig. 9). Die Laschen 12 sind vorzugsweise einstückig mit den Seitenteilen 14, 15, 20, 21 des Rahmens 11 an diesen angeformt (Fig. 3, 4, 5, 6, 7, 7A, 8, 8A, 9 und 10).

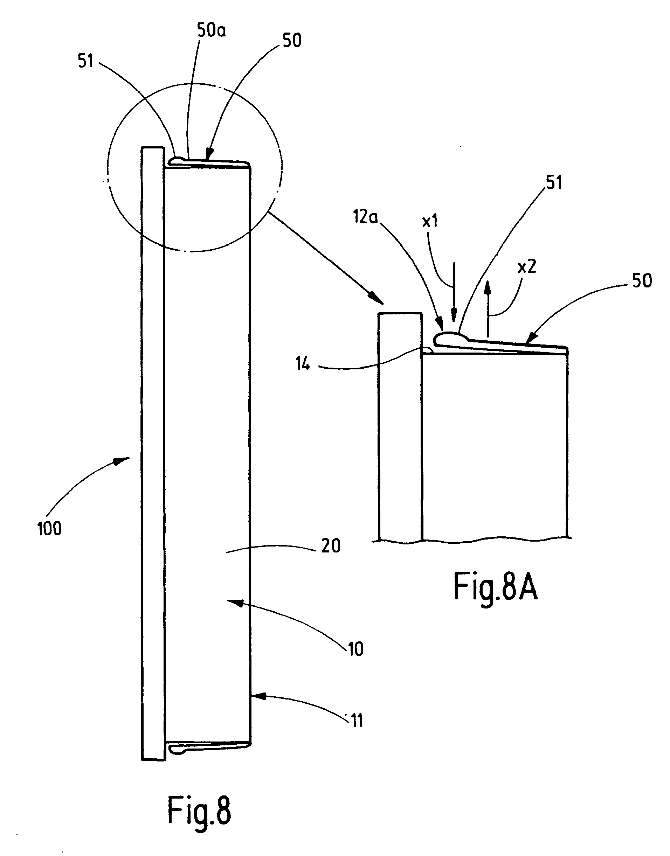

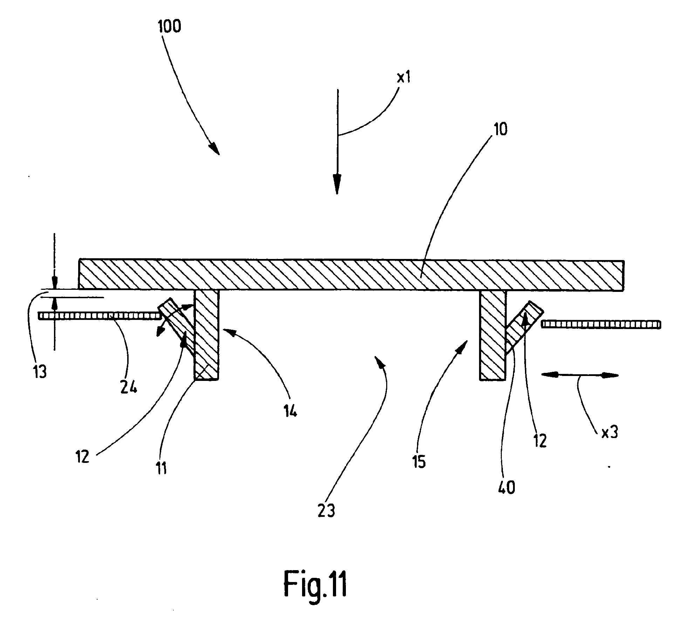

Sobald der Filterlüfter 100 weit genug in den Ausschnitt 23 der Montagewand 24 eingeschoben ist, wobei die Laschen 12 in Pfeilrichtung X1 gegen die Wandfläche der Seitenwand 14 gedrückt werden, federn die Laschen 12 in Pfeilrichtung X2 in ihre Ausgangsposition zurück und verriegeln den Filterlüfter 100 in seiner eingesetzten Position (Fig. 8 und 8A). Zum Entfernen des Filterlüfters 100 können die Laschen 12 in Pfeilrichtung X1 wieder leicht nach innen gedrückt werden (Fig. 11).

Um den Filterlüfter 100 beispielsweise an einem Metall- oder Kunststoffgehäuse eines Computers, eines Schaltschranks o. dgl. zu befestigen, ist der Abstand beziehungsweise Zwischenraum 13 zwischen einer oberen Kante 25 einer Lasche 12 und einer Montagewandanlagekante des Grundgehäuses 10 vorzugsweise in einem Bereich zwischen ein und vier Millimeter gewählt (Fig. 11).

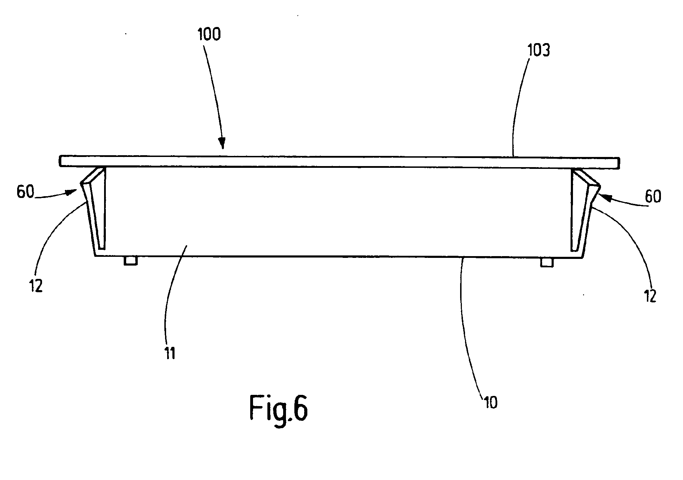

Dabei können die Laschen 12 entweder am Rahmen 11 in den Eckbereich 16, 17, 18, 19 des Rahmens 11 angeordnet sein oder mittig an einer Seitenwand 14, 15, 20, 21 (Fig. 3). An dem Rahmen 11 können die Laschen 12 auch in sonstiger beliebiger Weise verteilt angeordnet sein. Die Laschen 12 können in an sich beliebiger weise ausgeformt sein, bevorzugt jedoch dreieckig oder rechteckig. Die Laschen 12 sind aus dem Wandmaterial des Rahmens 11 herausgeformt (Fig. 9) oder angeformt (Fig. 6), so dass die Seitenwände 14, 15, 20, 21 des Rahmens 11 immer geschlossene Wandflächen bilden.

Die Anzahl der Laschen 12 kann beliebig gewählt sein, ebenso deren Anordnung am Rahmen 11. Neben einer Anordnung der Laschen 12 in den Eckbereichen 16, 17, 18, 19 können Laschen 12 auch in den mittigen Seitenwandbereichen des Rahmens 11 vorgesehen sein. Mindestens zwei Laschen 12 sollten an sich gegenüberliegenden Seitenwänden des Rahmens 11 vorgesehen sein. Die Laschen 12 bestehen bevorzugterweise aus dem Material des Rahmens 11, jedoch weisen die Laschen eine federelastische Ausgestaltung auf, aufgrund der die Lasche 12 nach Aufhebung eines auf die Laschen ausgeübten Druckes zurückfedern können.

Um den Filterlüfter 100 im montierten Zustand, d. h. wenn die Montagewandanlagekante beziehungsweise das Grundgehäuse 10 im Wesentlichen bündig und flächig an der Montagewand 24 anliegt, abzudichten, ist eine um den Filterlüfter 100 durchgehend umlaufende Gummidichtung 22 aus einem hierfür geeigneten Kunststoffmaterial vorgesehen. Insbesondere ist die Gummidichtung 22 in einer Nut eingeklebt, um das Eindringen von Luft und/oder Feuchtigkeit zwischen Filterlüfter 100 und Montagewand 24 zu vermeiden (Fig. 1 und 9).

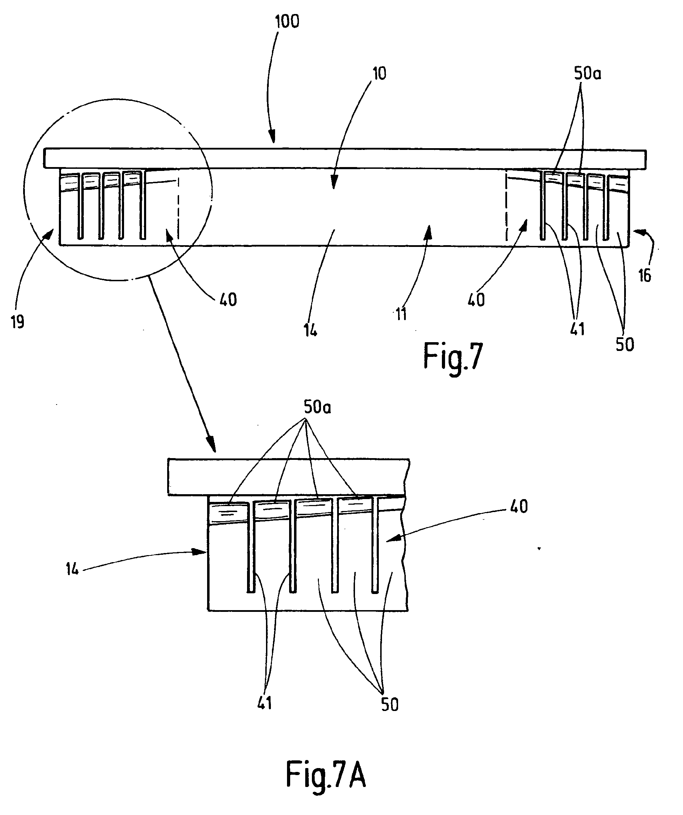

Jede an dem Rahmen 11 des Grundgehäuses 10 des Filterlüfters 100 angebrachte Lasche 12 ist als plattenförmiger Zuschnitt 40 ausgebildet, die zur Ausbildung von federelastischen Rastzungen 50 mit einer Anzahl von Schlitzen 41 versehen ist (Fig. 7, 7A, 9 und 10). Jeder plattenförmige Zuschnitt 40 ist einendseitig an der Wandfläche 11a des Rahmens 11 angeformt. Die Anzahl der Schlitze 41 kann dabei beliebig und somit auch die Anzahl der Rastzungen 50 gewählt sein. Diese federelastischen Rastzungen 50 weisen in etwa eine der Breite der Wandfläche 11a des Rahmens 11 entsprechende Länge auf. Deren dem Designdeckel 103 zugekehrten Enden 50a der Rastzungen 50 weisen außenwandseitig nockenartige Wandverstärkungen 51 auf (8, 8A und 9). Diese nockenartigen Wandverstärkungen 51 sind mit Gleitflächen versehen, um ein müheloses Einführen der Laschen in den Ausschnitt 23 der Montagewand 24 zu gewährleisten.

Die Längen der federelastischen Rastzungen 50 eines jeden plattenförmigen Zuschnittes 40 sind in Richtung zu den äußeren Kanten 11 b zweier aneinander stoßenden Seitenwänden 14, 15, 20, 21 des Rahmens 11 abnehmend ausgebildet (Fig. 9). Bevorzugterweise sind die freien Enden 50a geringfügig nach außen abgebogen.

Entsprechend Fig. 9 sind die Enden 50a der Rastzungen leicht abgebogen, wobei die Biegelinie BL schräg verlaufend ist, so dass sich abgebogene Endabschnitte unterschiedlicher Länge ergeben.

Die plattenförmigen Zuschnitte 40 mit ihren Rastzungen 50 bestehen bevorzugterweise aus einem Kunststoff, der die federelastischen Eigenschaften der Rastzungen 50 bewirkt.

### Bezugszeichenliste

- 100: Filterlüfter
- 101: Gebläseträger
- 102: Gebläse
- 103: Designdeckel
- 104: Lamellen
- 105: Filtermatte
- 106: Schutzgitter

- 10: Grundgehäuse
- 11: Rahmen
- 11a: Wandfläche
- 11b: Kante
- 12: Laschen
- 12a: Rastelemente
- 13: Zwischenraum
- 14: Seitenwand
- 15: Seitenwand
- 16: Eckbereich
- 17: Eckbereich
- 18: Eckbereich
- 19: Eckbereich
- 20: Seitenwand
- 21: Seitenwand
- 22: Dichtung
- 23: Ausschnitt
- 24: Montagewand
- 25: obere Kante

- 40: plattenförmiger Zuschnitt
- 41: Schlitze

- 50: Rastzungen
- 50a: Enden
- 51: Wandverstärkungen

- 60: Schnellbefestigung

- Y: Pfeilrichtung
- X: Pfeilrichtung
- X1: Pfeilrichtung
- X2: Pfeilrichtung
- X3: Pfeilrichtung

- BL: Biegelinie

## Patentansprüche

1. Fitterlüfter (100) mit einem Grundgehäuse (10) mit einem Rahmen (11), der mit Schnellbefestigungseinrichtungen (60) in Form von federelastischen, bevorzugterweise flügelartigen Laschen (12) zur Montage des Filterlüfters (100) in einem Wandausschnitt einer Montagewand versehen ist, wobei der Rahmen (11) um seinen Umfang durchgehend umlaufend geschlossen ausgebildet ist und die Laschen (12) an den Rahmen (11) angeformt sind,
**dadurch gekennzeichnet,**
**dass** die Laschen (12) als plattenförmige Zuschnitte (40) ausgebildet sind, die zur Ausbildung von federelastischen Rastzungen (50) mit einer Anzahl von Schlitzen (41) versehen sind, und
**dass** die Längen der federelastischen Rastzungen (50) eines jeden plattenförmigen Zuschnittes (40) in Richtung zu den äußeren Kanten (11b) zweier aneinander stoßender Seitenwandflächen (14, 15; 20, 21) des Rahmens (11) des Grundgehäuses (10) abnehmend sind, wobei die freien Enden (50a) der Rastzungen (50) geringfügig nach außen abgebogen sind, wobei die Biegelinie (BL) in Bezug auf die Längsrichtung der Rastzungen (50) derart schräg verlaufend ausgebildet ist, dass sich freie Enden (50a) unterschiedlicher Länge ergeben, wobei das freie Ende (50a) einer einer äußeren Kante (11b) nächstliegenden Rastzunge (50) eines plattenförmigen Zuschnittes (40) die größte Länge aufweist.

2. Filterlüfter (100) nach Anspruch 1,
**dadurch gekennzeichnet,**
**dass** an einer Oberseite (14) und/oder einer Unterseite (15) eines quadratischen oder rechteckigen Filterlüfters (100) jeweils an einem Eckbereich (16,17,18,19) eine Lasche (12) angeordnet ist.

3. Filterlüfter nach einem der Ansprüche 1 oder 2,
**dadurch gekennzeichnet,**
**dass** an einer oder mehreren Seitenwänden (14, 15, 20; 21) des Rahmens (11) jeweils eine Lasche (12) angeordnet ist.

4. Filterlüfter nach einem der Ansprüche 1 bis 3,
**dadurch gekennzeichnet,**
**dass** mindestens an jeweils zwei sich gegenüberliegenden Seitenwänden des Rahmens (11) mindestens eine Lasche (12) vorgesehen ist.

5. Filterlüfter nach einem der Ansprüche 1 bis 4,
**dadurch gekennzeichnet,**
**dass** die Laschen (12) dreieckig und/oder rechteckig ausgeformt sind.

6. Filterlüfter (100) nach einem der Ansprüche 1 bis 5,
**dadurch gekennzeichnet,**
**dass** an der umlaufenden Wandfläche (11 a) des Rahmens (11) des Grundgehäuses (10) mindestens zwei plattenförmige Zuschnitte (40) mit federelastischen Rastzungen (50) angeformt sind, die jeweils an zwei sich gegenüberliegenden Seitenwänden (14, 15; 20, 21) des Rahmens (11) an den Seitenwandflächen (11a) angeformt sind.

7. Filterlüfter (100) nach einem der Ansprüche 1 bis 6,
**dadurch gekennzeichnet,**
**dass** die plattenförmigen Zuschnitte (40) mit den federelastischen Rastzungen (50) mittig der Seitenwände (14, 15; 20, 21) des Rahmens (11) des Grundgehäuses (10) an den Seitenwandflächen angeformt sind.

8. Filterlüfter (100) nach einem der Ansprüche 1 bis 7,
**dadurch gekennzeichnet,**
**dass** vier plattenförmige Zuschnitte (40) mit den federelastischen Rastzungen (50) in den Eckbereichen (16, 17, 18, 19) des Grundgehäuses (10) an den Seitenwandflächen (14, 15; 20, 21) des Rahmens (11) angeformt sind, wobei die Anordnung der plattenförmigen Zuschnitte (50) an jeweils zwei sich gegenüberliegenden Seitenwandflächen (14, 15; 20, 21) des Rahmens (11) des Grundgehäuses (10) vorgesehen sind.

9. Filterlüfter (100) nach einem der Ansprüche 1 bis 8,
**dadurch gekennzeichnet,**
**dass** jeder plattenförmige Zuschnitt (40) mit seinen federelastischen Rastzungen (50) aus einem Kunststoff besteht.

10. Fliterlüfter (100) nach einem der Ansprüche 1 bis 9,
**dadurch gekennzeichnet,**
**dass** das Grundgehäuse (10) mit seinem Rahmen (11) des Filterlüfters (100) aus einem Kunststoff besteht.

11. Filterlüfter (100) nach einem der Ansprüche 1 bis 10,
**dadurch gekennzeichnet,**
**dass** das Grundgehäuse (10) des Filterlüfters (100) und die plattenförmigen Zuschnitte (40) mit den federelastischen Rastzungen (50) aus dem gleichen Kunststoff bestehen.

12. Filterlüfter (100) nach einem der Ansprüche 1 bis 11,
**dadurch gekennzeichnet,**
**dass** der Montagewandanlagekante ein Dichtungsmittel zugeordnet ist, insbesondere eine in eine Nut eingesetzte Gummidichtung (22).

## Claims

1. A filter fan (100) with a basic housing (10) with a frame (11) which is provided with quick fastening devices (60) in form of resilient, preferably wing-like straps (12) for mounting the filter fan (100) in a wall cut-out of a mounting wall, wherein the frame (11) is designed continuously closed all around its circumference and the straps (12) are moulded onto the frame (11),
**characterized in**
**that** the straps (12) are formed as plate-shaped cuts (40) which for forming resilient engagement tongues (50) are provided with a quantity of slits (41), and in
**that** the lengths of the resilient engagement tongues (50) of each plate-shaped cut (40) decrease in the direction of the outer edges (11 b) of two side wall surfaces (14, 15; 20, 21) of the frame (11) of the basic housing (10) abutting each other, wherein the free ends (50a) of the engagement tongues (50) are slightly bent outward, wherein the bending line (BL) with respect to the longitudinal direction of the engagement tongues (50) is formed orientated obliquely in such a manner that free ends (50a) of different length are obtained, wherein the free end (50a) of an engagement tongue (50) located next to an outer edge (11 b) of a plate-shaped cut (40) has the greatest length.

2. The filter fan (100) according to Claim 1,
**characterized in**
**that** on a top side (14) and/or a bottom side (15) of a square or rectangular filter fan (100) at each corner region (16, 17, 18, 19) a strap (12) is arranged.

3. The filter fan according to any one of the Claims 1 or 2,
**characterized in**
**that** on one or a plurality of side walls (14, 15, 20; 21) of the frame (11) a strap (12) each is arranged.

4. A filter fan according to any one of the Claims 1 to 3,
**characterized in**
**that** at least on every two opposing side walls of the frame (11) at least one strap (12) is provided.

5. The filter fan according to any one of the Claims 1 to 4,
**characterized in**
**that** the straps (12) are triangular and/or rectangular in shape.

6. The filter fan (100) according to any one of the Claims 1 to 5,
**characterized in**
**that** at least two plate-shaped cuts (40) with resilient engagement tongues (50) are moulded onto the circumferential wall surface (11 a) of the frame (11) of the basic housing (10), each of which is moulded onto two opposing side walls (14, 15; 20, 21) of the frame (11) on the side wall surfaces (11a).

7. The filter fan (100) according to any one of the Claims 1 to 6,
**characterized in**
**that** the plate-shaped cuts (40) with the resilient engagement tongues (50) are moulded onto the side wall surfaces in the middle of the side walls (14, 15; 20, 21) of the frame (11) of the basic housing (10).

8. The filter fan according to any one of the Claims 1 to 7,
**characterized in**
**that** four plate-shaped cuts (40) with the resilient engagement tongues (50) are moulded onto the side wall surfaces (14, 15; 20, 21) of the frame (11) in the corner regions (16, 17, 18, 19) of the basic housing (10), wherein the arrangement of the plate-shaped cuts is provided on every two opposite side wall surfaces (14, 15; 20, 21) of the frame (11) of the basic housing (10).

9. The filter fan (100) according to any one of the Claims 1 to 8,
**characterized in**
**that** each plate-shaped cut (40) with its resilient engagement tongues (50) consists of a plastic material.

10. The filter fan according to any one of the Claims 1 to 9,
**characterized in**
**that** the basic housing (10) with its frame (11) of the filter fan (100) consists of a plastic material.

11. The filter fan (100) according to any one of the Claims 1 to 10,
**characterized in**
**that** the basic housing (10) of the filter fan (100) and the plate-shaped cuts (40) with the resilient engagement tongues (50) consist of the same plastic material.

12. The filter fan (100) according to any one of the Claims 1 to 11,
**characterized in**
**that** the mounting wall contact edge is assigned a sealing means, more preferably a rubber seal (22) inserted into a groove.

## Revendications

1. Ventilateur à filtre (100) comportant un logement de base (10) avec un châssis (11), qui est pourvu de dispositifs de fixation rapide (60) sous la forme de languettes (12) de type ailettes de préférence, élastiques par ressort en vue du montage du ventilateur à filtre (100) dans une découpe de paroi d'une paroi de montage, dans lequel le châssis (11) est configuré de manière fermée en continu sur tout le tour de sa circonférence et les languettes (12) sont façonnées sur le châssis (11),
**caractérisé en ce que**
les languettes (12) sont réalisées comme des pièces découpées (40) en forme de plaque, qui sont pourvues d'une pluralité de fentes (41) à des fins de réalisation des languettes d'encliquetage (50) élastiques par ressort, et
**en ce que** les longueurs des languettes d'encliquetage (50) élastiques par ressort vont en diminuant dans la direction allant vers les bords extérieurs (11 b) de deux surfaces de parois latérales (14, 15 ; 20, 21) butant l'une sur l'autre du châssis (11) du logement de base (10), dans lequel les extrémités libres (50a) des languettes d'encliquetage (50) sont courbées au minimum vers l'extérieur, dans lequel la ligne de courbure (BL) est réalisée en s'étendant en oblique par rapport à la direction longitudinale des languettes d'encliquetage (50), de telle sorte que des extrémités libres (50a) de longueurs différentes soient obtenues, dans lequel l'extrémité libre (50a) d'une languette d'encliquetage (50) immédiatement suivante d'une arête extérieure (11b) d'une pièce de coupée (40) en forme de plaque présente la plus grande longueur.

2. Ventilateur à filtre (100) selon la revendication 1,
**caractérisé en ce que**
sur un côté supérieur (14) et/ou un côté inférieur (15) d'un ventilateur à filtre (100) carré ou rectangulaire, une languette (12) est respectivement disposée sur une zone de coin (16, 17, 18, 19).

3. Ventilateur à filtre selon une des revendications 1 ou 2,
**caractérisé en ce que**
sur une ou plusieurs parois latérales (14, 15 ; 20, 21) du châssis (11), une languette (12) est respectivement disposée.

4. Ventilateur à filtre selon une des revendications 1 à 3,
**caractérisé en ce que**
au moins sur deux parois latérales du châssis (11) respectivement en vis-à-vis, au moins une languette (12) est prévue.

5. Ventilateur à filtre selon une des revendications 1 à 4,
**caractérisé en ce que**
les languettes (12) sont façonnées en triangle et/ou en rectangle.

6. Ventilateur à filtre (100) selon une des revendications 1 à 5,
**caractérisé en ce que**
sur la surface de paroi (11a) faisant le tour du châssis (11) du logement de base (10), au moins deux pièces découpées (40) en forme de plaque sont façonnées avec des languettes d'encliquetage (50) élastiques par ressort, qui sont respectivement façonnées sur deux parois latérales (14, 15 ; 20, 21) en vis-à-vis du châssis (11) sur les surfaces de parois latérales (11a).

7. Ventilateur à filtre (100) selon une des revendications 1 à 6,
**caractérisé en ce que**
les pièces découpées (40) en forme de plaque sont façonnées avec les languettes d'encliquetage (50) élastiques par ressort au centre des parois latérales (14, 15 ; 20, 21) du châssis (11) du logement de base (10) sur les surfaces de parois latérales.

8. Ventilateur à filtre selon une des revendications 1 à 7,
**caractérisé en ce que**
quatre pièces découpées (40) en forme de plaque sont façonnées avec les languettes d'encliquetage (50) élastiques par ressort dans les zones de coin (16, 17, 18, 19) du logement de base (10) sur les surfaces de parois latérales (14, 15 ; 20, 21) du châssis, dans lequel la disposition des pièces découpées (50) en forme de plaque sur respectivement deux surfaces de parois latérales (14, 15 ; 20, 21) en vis-à-vis du châssis (11) du logement de base (10) est prévue.

9. Ventilateur à filtre (100) selon une des revendications 1 à 8,
**caractérisé en ce que**
chaque pièce découpée (40) en forme de plaque avec ses languettes d'encliquetage (50) élastiques par ressort est constituée d'un plastique.

10. Ventilateur à filtre (100) selon une des revendications 1 à 9,
**caractérisé en ce que**
le logement de base (10) avec son châssis (11) du ventilateur à filtre (100) est constitué d'un plastique.

11. Ventilateur à filtre (100) selon une des revendications 1 à 10,
**caractérisé en ce que**
le logement de base (10) du ventilateur à filtre (100) et les pièces découpées (40) en forme de plaque avec les languettes d'encliquetage (50) élastiques par ressort sont constitués du même plastique.

12. Ventilateur à filtre (100) selon une des revendications 1 à 11,
**caractérisé en ce que**
un moyen d'étanchéité est affecté à l'arête d'installation de paroi de montage, notamment un joint d'étanchéité (22) en caoutchouc inséré dans une rainure.
